# EUROPEAN PATENT SPECIFICATION

(11) **EP 1 456 940 B1**
(45) Date of publication and mention of the grant of the patent: **18.12.2013**
(21) Application number: 02789700.8
(22) Date of filing: 14.11.2002
(51) Int. Cl.: H03B 5/24, H03J 3/20, H03H 7/01, H01P 1/00

(54) **LOW NOISE OSCILLATOR**
RAUSCHARMER OSZILLATOR
OSCILLATEUR A FAIBLE BRUIT

(30) Priority: 14.11.2001 US 4521; 18.03.2002 US 101560
(43) Date of publication of application: 15.09.2004
(73) Proprietor: Qualcomm Incorporated, San Diego, CA 92121 (US)
(72) Inventor: KIM, Beomsup, Cupertino, CA 95125 (US)
(74) Representative: Freeman, Jacqueline Carol
(86) International application number: PCT/US2002/036823
(87) International publication number: WO 2003/043175

(56) References cited:
- EP-A1- 0 900 997
- US-A- 3 731 230
- US-A- 4 940 939
- US-A- 5 561 399
- US-A- 5 635 877
- US-A- 5 852 385
- US-A- 5 892 425
- US-A- 5 912 596
- US-A- 6 094 103
- US-A- 6 104 253
- US-B1- 6 232 847
- US-B1- 6 433 653

## Description

### Field of the Invention

The present invention relates generally to voltage controlled oscillators. A phase synchronous multiple LC tank oscillator with inductive coupling is disclosed.

### Background Of The Invention

LC tank oscillators have been used for communication systems, particularly for high frequency LO (local oscillator) signal generation for microwave or radio frequency apparatus. An LC tank circuit includes inductors and capacitors arranged to oscillate by exchanging current or voltage between inductors and capacitors with a finite frequency. Since small resistance in the inductors and capacitors tends to dissipate the energy in the oscillator, the LC tank loses energy and eventually stops oscillating. A negative resistance usually generated by active devices included in the oscillator compensates for energy dissipation caused by resistance and sustains the oscillation. However, even though the resistance is compensated in this manner by the active devices, the resistance still degrades the oscillation quality by affecting the oscillation amplitude, phase noise and oscillation purity (i.e. whether the oscillation has a pure sine wave shape). One measure of quality of oscillation is called the "Quality Factor. "The Quality Factor is defined as the ratio of the energy stored in the LC tank to the energy dissipated in the resistor per oscillation cycle.

Thus, it is desirable that inductors used in an LC tank oscillator have minimum resistance. Unfortunately, on chip inductors generally have high resistance. Low quality oscillation generally results due to the substrate resistance and Ohmic resistance of the metal used in on chip inductors. Therefore, the phase noise performance of oscillators using on-chip inductors is poor and generally not suitable for high quality wireless devices such as cellular phones or satellite communication equipment.

One of the ways that noise is introduced into a cascaded oscillator is through the wires and switches that comprise the electrical connections between oscillators that couple the oscillators and cause synchronous oscillation. It would be useful if such noise could be reduced.

US4940939 discloses an apparatus for measuring the magnetic content of non-metallic samples includes operating and reference sine wave oscillators of identical frequency, a mutual synchronization loop for said oscillators, and a phase meter connected to the oscillator outputs for measuring the phase shift between their oscillations, when a test sample is placed inside the inductance coil of the operating oscillator.

What is needed is an oscillator design that will enable on chip inductors to be used for such high quality wireless devices.

### Summary Of The Invention

A phase synchronous multiple LC tank oscillator is disclosed. The phase synchronous multiple LC tank oscillator comprising:
a plurality of oscillator stages configured to oscillate synchronously wherein the phase of each of the plurality of oscillator stages is substantially the same and
wherein the plurality of oscillator stages are inductively coupled wherein a first inductor and a second inductor are disposed on a top layer of an integrated circuit,
characterised in that at a crossing point with the second inductor, a portion of the first inductor is disposed on at least one layer below the top layer and the portion of the first inductor returns to the top layer after the crossing point.

These and other features and advantages of the present invention will be presented in more detail in the following detailed description and the accompanying figures which illustrate by way of example the principles of the invention.

### Brief Description Of The Drawings

The present invention will be readily understood by the following detailed description in conjunction with the accompanying drawings, wherein like reference numerals designate like structural elements, and in which:
Figure 1 is a block diagram illustrating an architecture used in one embodiment wherein in synchronising phase is achieved by outputting signals from each oscillator stage into adjacent oscillator stages.
Figure 2 is a block diagram illustrating an architecture used in one embodiment wherein in synchronising phase is achieved by outputting signals from each oscillator stage into both adjacent and non-adjacent oscillator stages.
Figure 3 is a block diagram illustrating an architecture used in one embodiment wherein synchronising phase is achieved by having each oscillator stage receive an input from every other oscillator stage.
Figure 4A is a block diagram illustrating an LC tank oscillator used in one embodiment.
Figure 4B is a block diagram illustrating an alternative LC tank oscillator used in an embodiment wherein the oscillator stages each include four inputs.
Figure 5 is a diagram illustrating how corresponding inductors from different oscillator stages are physically configured.
Figure 6A is a block diagram illustrating an electronically coupled phase synchronous LC tank oscillator.
Figure 6B is a block diagram illustrating an alternate design for an electrically coupled phase synchronous oscillator.
Figure 6C is a diagram illustrating another LC tank oscillator architecture that utilizes four oscillator stages that oscillate synchronously.
Figure 7 is a diagram illustrating an LC tank oscillator.
Figure 8A is a diagram illustrating a rectangular physical layout of four inductors that are mutually inductive.
Figure 8B is a diagram illustrating an octagonal physical layout for four inductors that are mutually inductive.
Figure 8C is a diagram illustrating a circular layout for four inductors that are mutually inductive.
Figure 8D is a diagram illustrating in detail how one inductor passes below another inductor at a crossing point.
Figure 9A is a diagram illustrating a two oscillator stage synchronous LC tank oscillator wherein the oscillators are inductively coupled without electrical coupling.
Figure 9B is a diagram illustrating a layout for two inductors that are mutually inductive.
Figure 9C is a diagram illustrating a four oscillator stage synchronous LC tank oscillator wherein the oscillators are inductively coupled without electrical coupling.
Figure 10 is a diagram illustrating a four oscillator stage synchronous LC tank oscillator wherein the oscillators are inductively coupled with electrical coupling selectively included and controlled by a set that switches.

### Detailed Description

A detailed description of a preferred embodiment of the invention is provided below. While the invention is described in conjunction with that preferred embodiment, it should be understood that the invention is not limited to any one embodiment. On the contrary, the scope of the invention is limited only by the appended claims and the invention encompasses numerous alternatives, modifications and equivalents. For the purpose of example, numerous specific details are set forth in the following description in order to provide a thorough understanding of the present invention. The present invention may be practiced according to the claims without some or all of these specific details. For the purpose of clarity, technical material that is known in the technical fields related to the invention has not been described in detail so that the present invention is not unnecessarily obscured.

An oscillator architecture is disclosed that generates a high quality oscillation signal output using on chip inductors or other low quality inductors. The phase noise performance of the resulting oscillator is improved so that it can meet the high performance requirements for a wireless device. A plurality of synchronous low quality oscillators form a high quality oscillator by synchronizing the oscillation phase with other peer oscillators. Because the oscillations are synchronized, the magnetic flux may be shared among corresponding inductors used in the different oscillators without increasing resistance of the individual inductors.

Phase-synchronous signal addition of multiple oscillator outputs improves phase noise performance because the output signal power increases by 6dB per each additional oscillator output in phase while the noise power increases by 3dB per each additional oscillator output. Thus, the disclosed multiple oscillator architecture effectively achieves high purity oscillation even though the individual oscillators are relatively low quality.

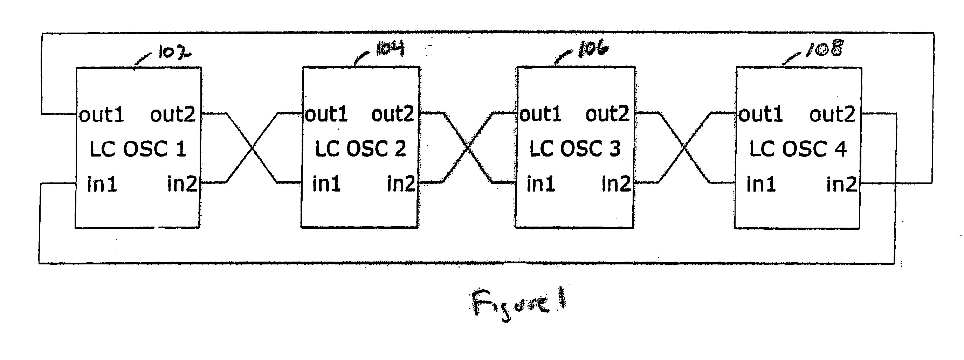

Figure 1 is a block diagram illustrating an architecture used in one embodiment wherein synchronizing phase is achieved by outputting signals from each oscillator stage into adjacent oscillator stages. The architecture includes four oscillator stages 102, 104, 106 and 108. Each oscillator includes two inputs and two outputs. Each oscillator stage outputs its own output signal to two adjacent oscillator stages and also receives inputs from the two adjacent oscillator stages. For example, oscillator 104 includes a first output that is connected to an input of adjacent oscillator 102 and a second output that is connected to an input of its other adjacent oscillator 106. In addition, oscillator 104 includes a first input that is connected to an output of adjacent oscillator 102 and a second input that is connected to an output of its other adjacent oscillator 106. As a result, all of the oscillators oscillate synchronously.

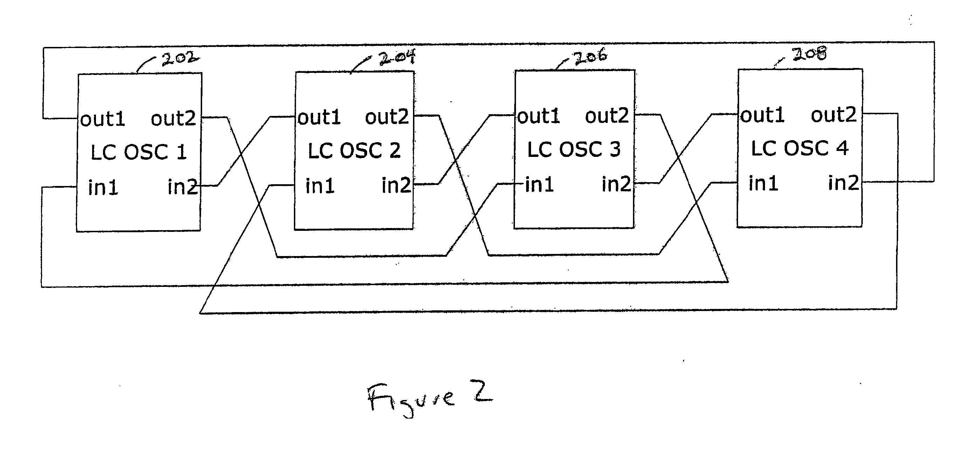

Figure 2 is a block diagram illustrating an architecture used in one embodiment where synchronizing phase is achieved by outputting signals from each oscillator stage into both adjacent and nonadjacent oscillator stages. The architecture includes four oscillator stages 202, 204, 206 and 208. Each oscillator includes two inputs and two outputs. Each oscillator stage outputs its own output signal to one adjacent oscillator stage and one nonadjacent oscillator stage. For example, oscillator 204 includes a first output that is fed back to an input of oscillator 202 and a second output that is fed forward, skipping a stage, to an input oscillator 206. In addition, oscillator 204 includes a first input that is connected to an output of nonadjacent oscillator 208 and a second input that is connected to an output of adjacent oscillator 206. As a result, all of the oscillators oscillate synchronously.

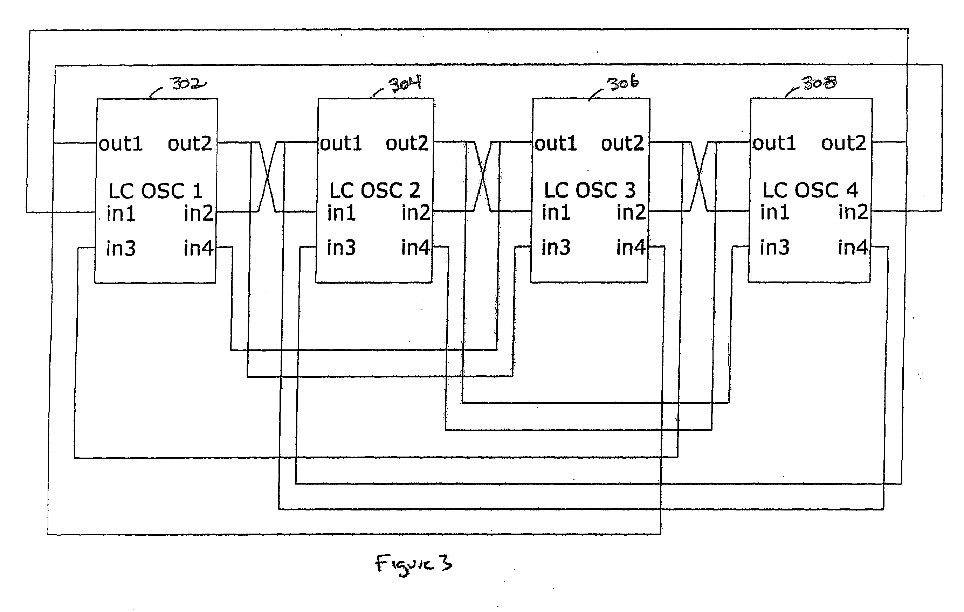

Figure 3 is a block diagram illustrating an architecture used in one embodiment where synchronizing phase is achieved by having each oscillator stage receive an input from every other oscillator stage. The architecture includes four oscillator stages 302, 304, 306 and 308. Each oscillator includes four inputs and two outputs that are each split. Each oscillator stage outputs its own output signal every other oscillator stage with one of the other oscillator stages receiving the output twice. For example, oscillator stage 304 includes a first output that is fed to an input of oscillator stage 302 and an input of oscillator stage 308. Oscillator stage 304 also includes a second output that is fed to two inputs of oscillator stage 306. As a result, all of the oscillators oscillate synchronously.

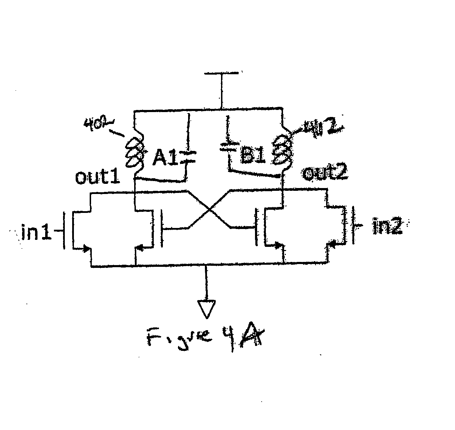

Figure 4A is a block diagram illustrating an LC tank oscillator used in one embodiment. LC tank oscillator stage 400 includes a first inductor 402 and a second inductor 412. In the architectures described above, four substantially identical oscillators are configured according to the various illustrated schemes. Each oscillator stage includes its own two inductors, one corresponding to inductor 402 and one corresponding to inductor 412. In other embodiments, other LC tank configurations are used.

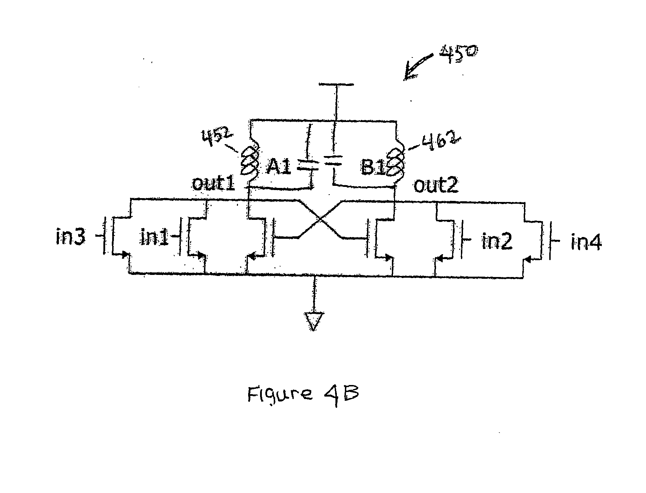

Figure 4B is a block diagram illustrating an alternative LC tank oscillator used in an embodiment where the oscillator stages each include four inputs. LC tank oscillator stage 450 includes a first inductor 452 and a second inductor 462. Substantially identical oscillator stages are configured according to a selected multiple oscillator stage structure. Each oscillator stage includes its own two inductors, one corresponding to inductor 452 and one corresponding to inductor 462.

As mentioned above, in most conventional inductors, increasing inductance increases the resistance of the inductor because the length of the coiled wire that comprises the inductor is increased. The increased length metal wire has higher resistance and the quality of the oscillation is not improved. If a phase synchronous multiple tank oscillator architecture is used, then the magnetic flux is generated in the same direction among corresponding inductors in the participating oscillators. If the corresponding inductors are physically arranged so that their fluxes are added, then the mutual inductance among the inductors may have the effect of increasing the effective inductance of each individual inductor without increasing the resistance of the inductor. As a result, the quality of the oscillation generated from the phase synchronous multiple LC tank oscillator may be improved. In addition, if the inductors from the oscillators are overlapped or arranged concentrically, space on the surface of the chip may be saved.

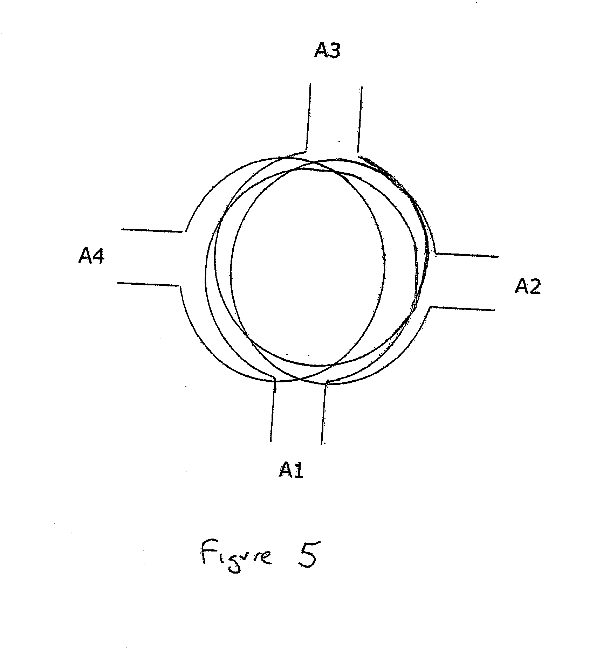

Figure 5 is a diagram illustrating how corresponding inductors from different oscillator stages are physically configured in one embodiment to increase their mutual inductance by adding their fluxes. As explained above, each of the oscillator stages oscillate synchronously and so the corresponding fluxes are generated in the same direction. Inductors 402, 404, 406, and 408 include coils each having one or more loops. The coils are physically arranged concentrically about a common center, which causes the fluxes to add.

Several embodiments of a phase synchronous multiple LC tank oscillator have been described wherein four oscillator stages are included. In other embodiments, a different number of synchronous oscillator stages are used. Also, various ways of connecting the oscillators are described that cause the oscillators to oscillate in a synchronous manner. In different embodiments, the oscillators are connected in different manners to oscillate synchronously. Furthermore, oscillators having two inputs have been shown in the examples given. In other embodiments, oscillators having more than two inputs are used.

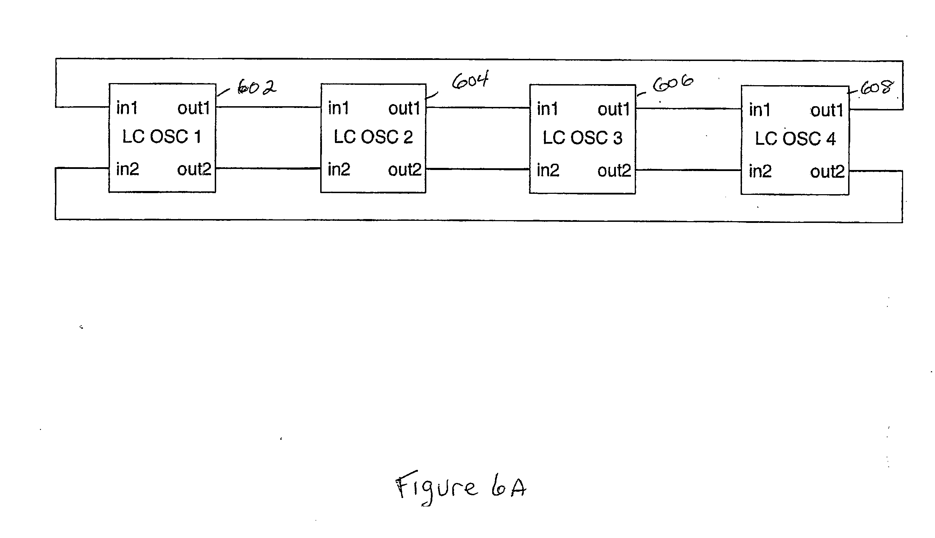

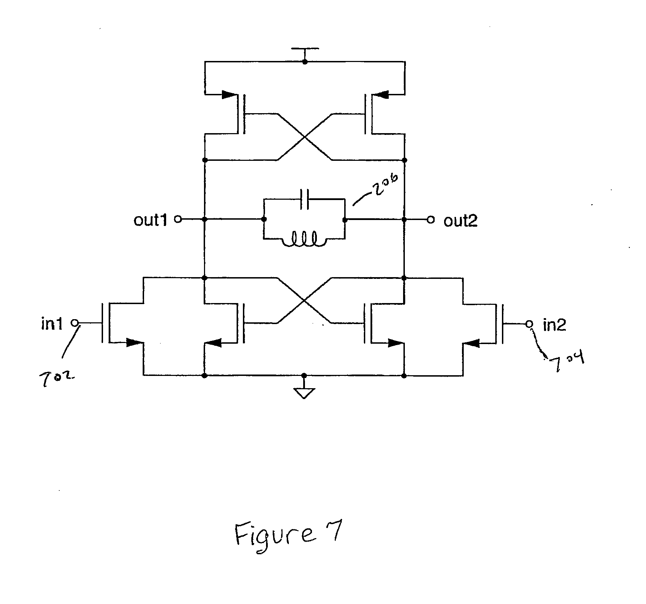

Figure 6A is a block diagram illustrating an electrically coupled phase synchronous LC tank oscillator. Each oscillator stage, 602, 604, 606, and 608 includes a pair of inputs and a pair of outputs. A preferred design for each oscillator stage is shown in Figure 7. Each output is connected to an input of the next oscillator in the chain. This configuration results in each of the oscillators oscillating in a synchronous manner.

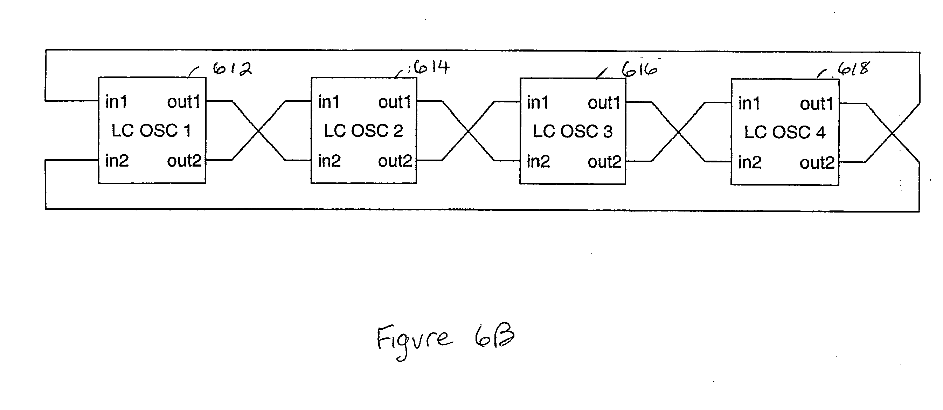

Figure 6B is a block diagram illustrating an alternate design for an electrically coupled phase synchronous oscillator. Each oscillator stage, 612, 614, 616, and 618 includes a pair of inputs and a pair of outputs. A preferred design for each of the LC tank oscillators is shown in Figure 7. Each output is connected to an input of the next oscillator in the chain, with a different input selected than the input selected in Figure 1. This configuration results in each of the oscillators oscillating in a synchronous manner.

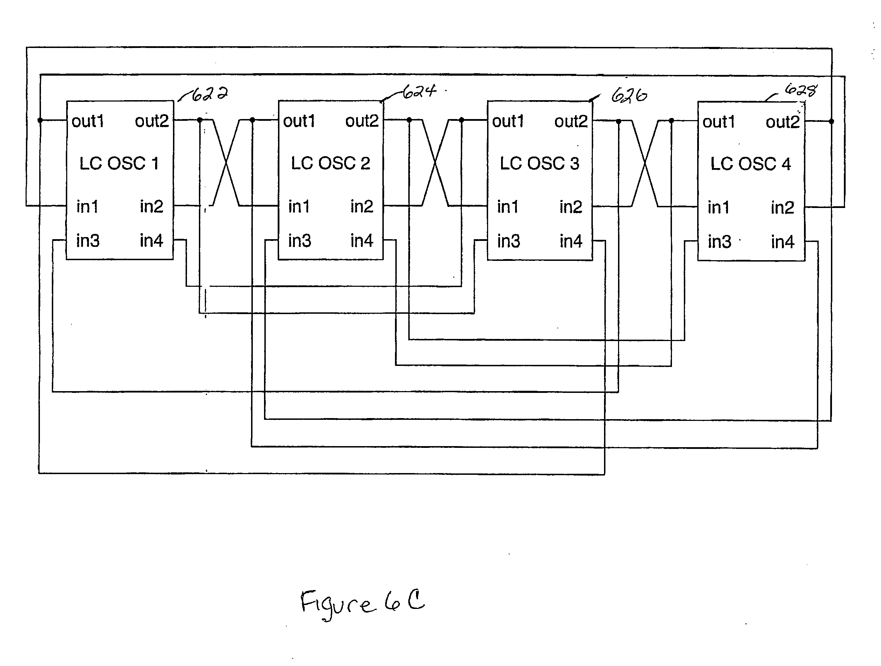

Figure 6C is a diagram illustrating another LC tank oscillator architecture that utilizes four oscillator stages, 622, 624, 626, and 628 that oscillate synchronously. Each oscillator stage includes four inputs and two outputs. The inputs and outputs are again configured to cause the oscillator stages to oscillate in phase.

Figure 7 is a diagram illustrating an LC tank oscillator. LC tank oscillator 700 includes input node 702 and input node 704. The input nodes are coupled to the LC portion of the circuit 706 via a network of transistors. Because the individual LC tank oscillators oscillate synchronously, the inductors may be configured in a mutually inductive manner. Each inductor is laid out so that the area in which its flux is contained substantially coexists with the flux area of the other inductors that comprise the other oscillators in the ring.

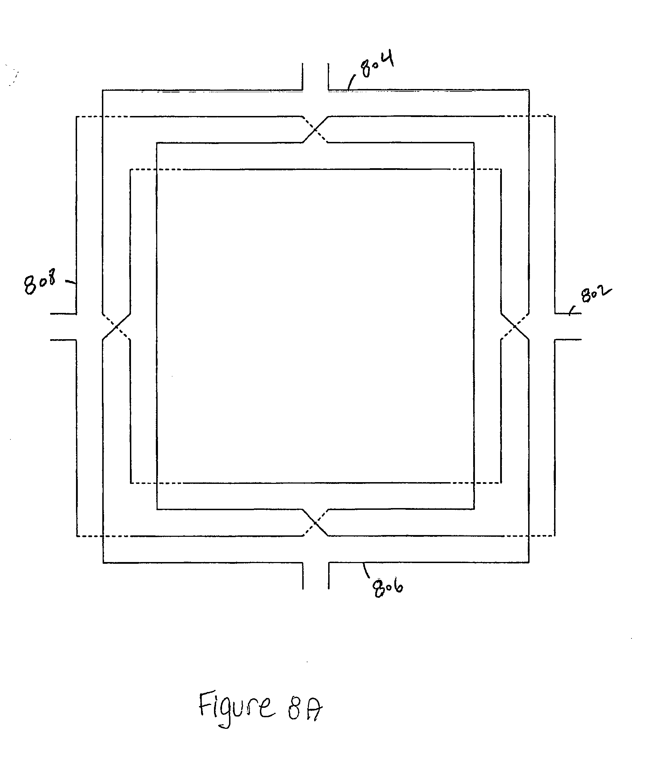

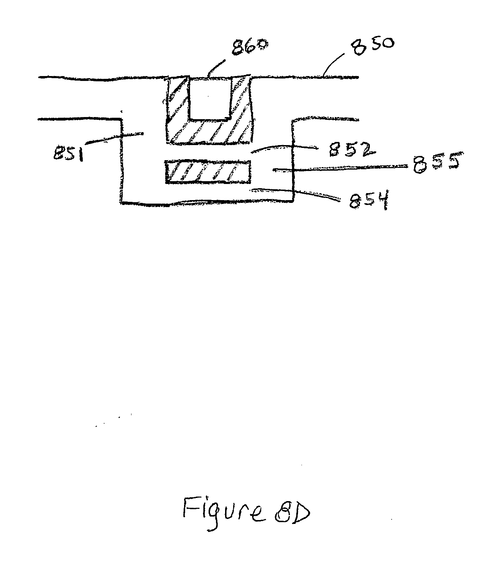

Figure 8A is a diagram illustrating a rectangular physical layout for 4 inductors that are mutually inductive in the manner described above. The layout includes inductors 802, 804, 806 and 808. The layout is symmetric and the flux area of the inductors substantially overlaps. Dashed lines are used to illustrate when one inductor wire drops to a lower layer to pass under another inductor wire. This layout is implemented using a multilayer metal structure as described in Figure 8D. Each conductor that forms a loop begins at a first upper layer, then transitions to a second lower layer to pass under another inductor when that is required and then transitions back to the first layer.

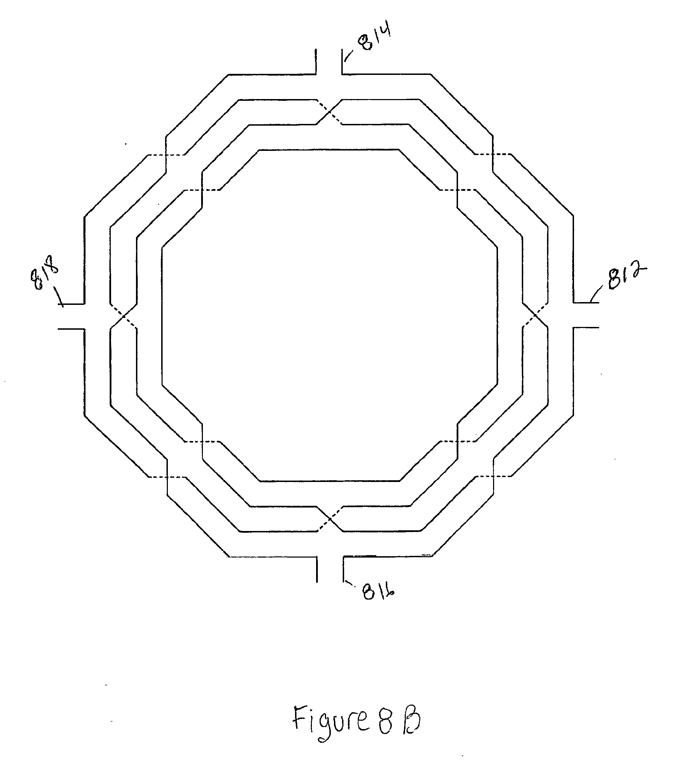

Figure 8B is a diagram illustrating an octagonal physical layout for 4 inductors that are mutually inductive in the manner described above. The layout includes inductors 812, 814, 816 and 818. The layout is symmetric and the flux area of the inductors substantially overlaps. Dashed lines are used to illustrate when one line passes under another line. This layout is implemented using a multilayer metal structure as described in Figure 8D. The octagonal layout shown has the advantage that the angle of the turns is less acute, which reduces current crowding.

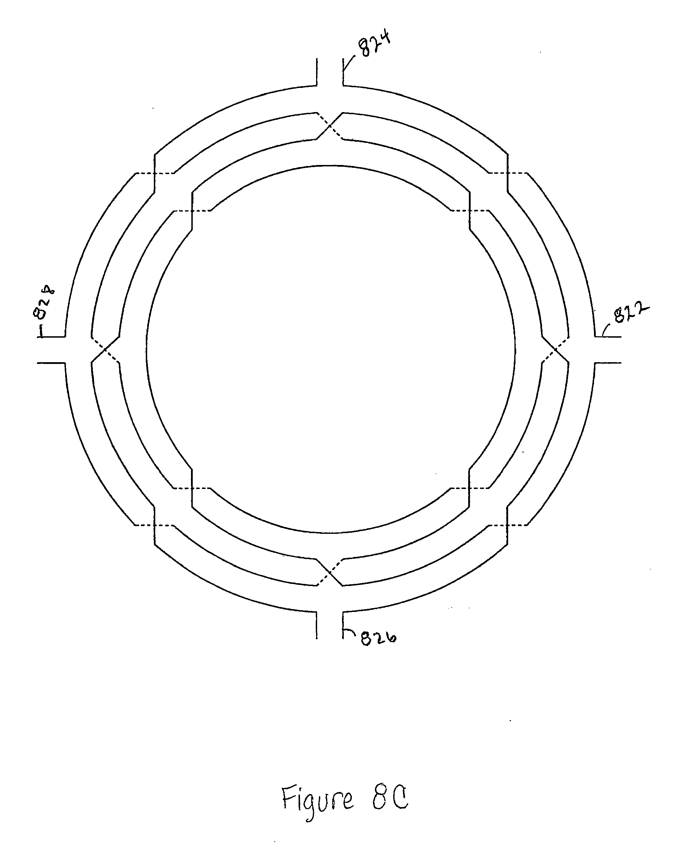

Figure 8C is a diagram illustrating a circular layout for 4 inductors that are mutually inductive in the manner described above. The layout includes inductors 822, 824, 826 and 828. The layout is symmetric and the flux area of the inductors substantially overlaps. Dashed lines are used to illustrate when one line passes under another line. This layout is implemented using a multilayer metal structure as described in Figure 8D. The circular layout shown has the advantage eliminating the angular turns, which reduces current crowding.

Figure 8D is a diagram illustrating in detail how one inductor passes below another inductor at a crossing point. Preferably, the inductors are laid out on a top metal layer. Depending on the manufacturing process, the top metal layer may be thicker (on the order of two or three times thicker in some embodiments) than the second layer that is just below the top layer. When the top layer is thicker than the lower layers, the lower layers tend to have higher resistance. This problem can be ameliorated by connecting the top layer to two or more lower layers in parallel. At a crossing point, one inductor is interrupted in the top layer and is connected to one or more lower layers using one or more vias. Once the crossing point has passed, the inductor resumes on the top layer and one or more vias connect the lower layers to the top layer.

In the example shown, inductor 850 is disposed in the top layer until a crossing point with inductor 860 is reached. Inductor 850 is interrupted in the top layer and is connected to the second layer and the third layer by via 851. Second layer portion 852 and third layer portion 854 of inductor 850 run below inductor 860. Once the crossing point is passed, via 855 connects second layer portion 852 and third layer portion 854 back to the top layer and inductor 850 resumes on the top layer. In different embodiments, different numbers of layers may be used. In general, only 2 layers are required, but additional layers may be used to lower the resistance of the portion of the inductor that drops down to a lower layer.

As noted above, in addition to the disclosed architectures using 4 oscillator stages, other 4 oscillator stage architectures may be used as well as architectures having different numbers of oscillators.

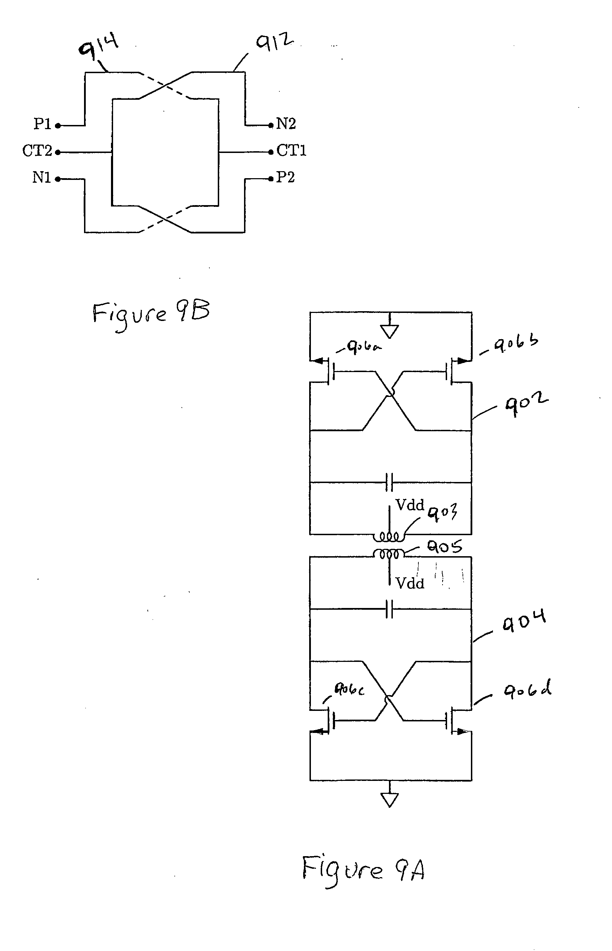

Figure 9A is a diagram illustrating a 2 oscillator stage synchronous LC tank oscillator where the oscillators are inductively coupled without electrical coupling. Oscillator 902 and oscillator 904 are inductively coupled through their inductors 903 and 905. Each of the inductors includes a center tap that is connected to a bias voltage Vdd. The inductive coupling causes the oscillator stages to oscillate synchronously without electrical coupling. By replacing electrical coupling with inductive coupling, the noise associated with the electrical coupling circuit is eliminated.

Figure 9B is a diagram illustrating a layout for 2 inductors that are mutually inductive in the manner described above. The inductors are laid out on a top layer with inductor 914 dropping down to a lower layer in order to cross under inductor 912 at the appropriate point. Each inductor includes a center tap. The area in which the magnetic flux is contained for each inductor substantially coexists with the flux area of the other inductor. In other embodiments, different shaped inductors are used, such as the hexagonal shape and circular shape shown above.

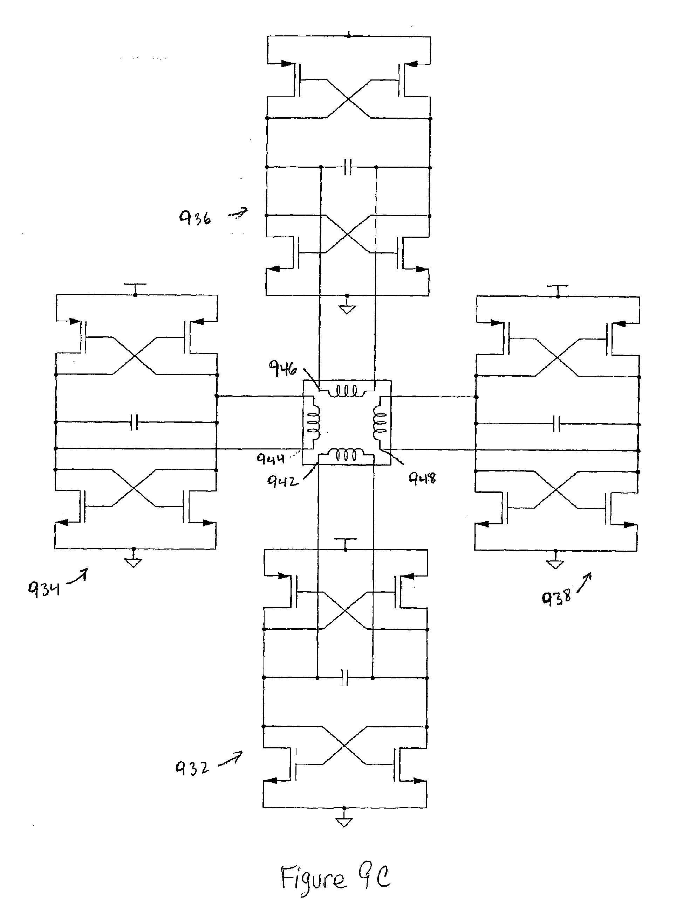

Figure 9C is a diagram illustrating a 4 oscillator stage synchronous LC tank oscillator where the oscillators are inductively coupled without electrical coupling. Oscillators 932, 934, 936, and 938 are inductively coupled through their inductors 942, 944, 946, and 948. The inductors are disposed in a manner as shown in Figures 8A-8C so that the areas in which flux is contained substantially overlap. The inductive coupling causes the oscillator stages to oscillate synchronously without electrical coupling. By replacing electrical coupling with inductive coupling, the noise associated with the electrical coupling circuit is eliminated.

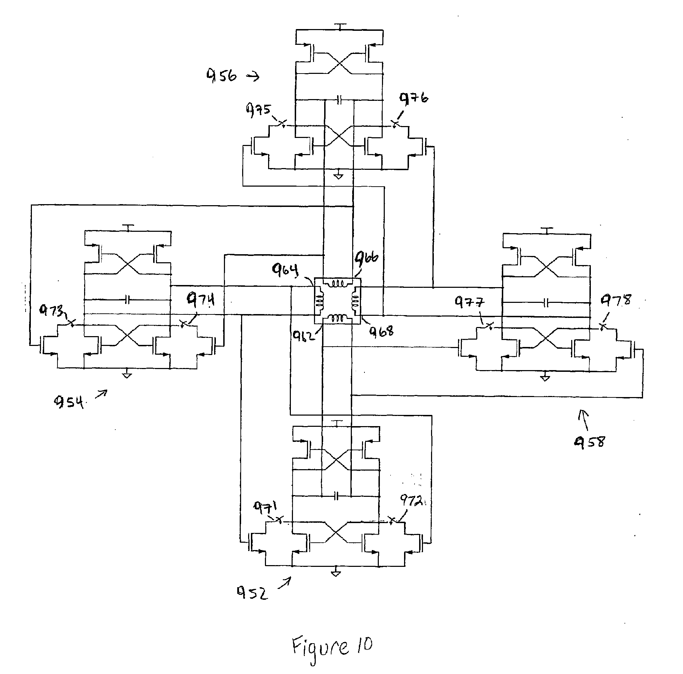

Figure 10 is a diagram illustrating a 4 oscillator stage synchronous LC tank oscillator where the oscillators are inductively coupled with electrical coupling selectively included and controlled by a set of switches. Electrical coupling is selectively connected or disconnected using the switches. Oscillators 952, 954, 936, and 938 are inductively coupled through their inductors 962, 964, 966, and 968. Switches 971, 972, 973, 975, 976, 977, and 978 selectively connect or disconnect electrical coupling among the oscillators. The inductors are disposed in a manner as shown in Figures 8A-8C so that the areas in which flux is contained substantially overlap. When the electrical coupling is deactivated using the switches, the inductive coupling causes the oscillator stages to oscillate synchronously without electrical coupling. By replacing electrical coupling with inductive coupling, the noise associated with the electrical coupling circuit is eliminated. A number of embodiments of LC tank oscillators have been described that include coupled inductors. In some embodiments, two or more oscillators are synchronized using inductive coupling without electrical coupling or with reduced electrical coupling. The synchronous coupling improves the phase noise of the oscillators. Also, the inductive coupling increases the Q, which improves the phase noise. Lower phase noise for the same power or lower power for the same phase noise is achieved compared to non-synchronous oscillators. The coupled inductors occupy less area since they overlap. Several embodiments of exemplary overlapping inductor layouts have been illustrated.

Although the foregoing invention has been described in some detail for purposes of clarity of understanding, it will be apparent that certain changes and modifications may be practiced within the scope of the appended claims. It should be noted that there are many alternative ways of implementing both the process and apparatus of the present invention. Accordingly, the present embodiments are to be considered as illustrative and not restrictive, and the invention is not to be limited to the details given herein, but may be modified within the scope and equivalents of the appended claims.

## Claims

1. A phase synchronous multiple LC tank oscillator comprising:
a plurality of oscillator stages (952, 954, 936, 938) configured to oscillate synchronously wherein the phase of each of the plurality of oscillator stages is substantially the same and
wherein the plurality of oscillator stages (952, 954, 936, 938) are inductively coupled wherein a first inductor (850, 962) and a second inductor (860, 964) are disposed on a top layer of an integrated circuit,
**characterised in that** at a crossing point with the second inductor (860), a portion of the first inductor (850) is disposed on at least one layer (852) below the top layer and the portion of the first inductor returns to the top layer after the crossing point.

2. A phase synchronous multiple LC tank oscillator as recited in claim 1 wherein the synchronous oscillation is substantially caused by magnetic coupling.

3. A phase synchronous multiple LC tank oscillator as recited in claim 1 wherein the synchronous oscillator stages (952, 954, 936, 938) are not substantially electrically coupled.

4. A phase synchronous multiple LC tank oscillator as recited in claim 1 wherein the synchronous oscillator stages (952, 954, 936, 938) are coupled electrically during a first time period and the electrical coupling is disconnected during a second time period.

5. A phase synchronous multiple LC tank oscillator as recited in claim 1 wherein the synchronous oscillator stages (952, 954, 936, 938) are coupled electrically during a first time period and the electrical coupling is reduced during a second time period.

6. A phase synchronous multiple LC tank oscillator as recited in claim 1 wherein the plurality of oscillator stages (952, 954, 936, 938) includes four oscillator stages.

7. A phase synchronous multiple LC tank oscillator as recited in claim 1 wherein the plurality of oscillator stages (952, 954, 936, 938) includes two oscillator stages.

8. A phase synchronous multiple LC tank oscillator as recited in claim 1 wherein the inductive coupling is achieved using two center tapped inductors.

9. A phase synchronous multiple LC tank oscillator as recited in claim 1 wherein the inductive coupling is achieved using inductors that are mutually inductive.

10. A phase synchronous multiple LC tank oscillator as recited in claim 1 wherein the inductive coupling is achieved using inductors having areas in which flux is contained that substantially coexist.

11. A phase synchronous multiple LC tank oscillator as recited in claim 1 wherein at least one of the oscillator stages (952, 954, 936, 938) includes a switch (971, 972, 973, 975, 976, 977, 978).

12. A phase synchronous multiple LC tank oscillator as recited in claim 1 wherein the phase synchronous multiple LC tank oscillator is used in a wireless transceiver.

13. A multiple LC tank oscillator as recited in claim 9 wherein the first inductor and second inductor are disposed such that the flux areas surrounded by the inductors overlap.

14. A multiple LC tank oscillator as recited in claim 9 wherein the first inductor and second inductor are disposed on three layers of an integrated circuit.

15. A multiple LC tank oscillator as recited in claim 9 wherein the portion of the first inductor is disposed on at least two layers below a layer that includes the second inductor.

16. A multiple LC tank oscillator as recited in claim 9 wherein the first inductor and second inductor each are arranged in a hexagonal shape.

17. A multiple LC tank oscillator as recited in claim 9 wherein the first inductor and second inductor each are arranged in a circular shape.

18. A multiple LC tank oscillator as recited in claim 9 wherein the first inductor drops down to a second layer when the first inductor and the second inductor cross.

19. A multiple LC tank oscillator as recited in claim 9 wherein the first inductor and second inductor are disposed in at most two layers of an integrated circuit.

20. A multiple LC tank oscillator as recited in claim 9 further including: a third oscillator stage (956) having a third inductor (966); and a fourth oscillator stage (958) having a fourth inductor (968); wherein the first inductor, the second inductor, the third inductor, and the fourth inductor are all mutually inductive.

21. A multiple LC tank oscillator as recited in claim 9 further including: a third oscillator stage having a third inductor; and a fourth oscillator stage having a fourth inductor; wherein the first inductor, the second inductor, the third inductor, and the fourth inductor are all mutually inductive and wherein the one of the inductors drops down to a second layer when two of the inductors cross.

22. A multiple LC tank oscillator as recited in claim 9 further including: a third oscillator stage having a third inductor; and a fourth oscillator stage having a fourth inductor; wherein the first inductor, the second inductor, the third inductor, and the fourth inductor are all mutually inductive and wherein the first inductor and the second inductor, the third inductor and the fourth inductor are disposed on two layers of an integrated circuit and wherein the first inductor and the second inductor are disposed on a top layer of the integrated circuit.

## Patentansprüche

1. Phasensynchroner Mehrfach-LC-Tank-Oszillator, der Folgendes umfasst:
eine Vielzahl von Oszillatorstufen (952, 954, 936, 938), wobei die Oszillatorstufen so konfiguriert sind, dass sie synchron schwingen, wobei die Phase von jeder der Vielzahl von Oszillatorstufen im Wesentlichen gleich ist, und
wobei die Vielzahl von Oszillatorstufen (952, 954, 936, 938) induktiv gekoppelt ist, wobei eine erste Induktionsspule (850, 962) und eine zweite Induktionsspule (860, 964) auf einer oberen Schicht eines integrierten Schaltkreises angeordnet sind,
**dadurch gekennzeichnet, dass** an einem Kreuzungspunkt mit der zweiten Induktionsspule (860) ein Teil der ersten Induktionsspule (850) auf mindestens einer Schicht (852) unter der oberen Schicht angeordnet ist und der Abschnitt der ersten Induktionsspule nach dem Kreuzungspunkt zu der oberen Schicht zurückkehrt.

2. Phasensynchroner Mehrfach-LC-Tank-Oszillator nach Anspruch 1, wobei die synchrone Schwingung im Wesentlichen durch magnetische Kopplung verursacht wird.

3. Phasensynchroner Mehrfach-LC-Tank-Oszillator nach Anspruch 1, wobei die Stufen (952, 954, 936, 938) des synchronen Oszillators nicht im Wesentlichen elektrisch gekoppelt sind.

4. Phasensynchroner Mehrfach-LC-Tank-Oszillator nach Anspruch 1, wobei die Stufen (952, 954, 936, 938) des synchronen Oszillators während eines ersten Zeitraums elektrisch gekoppelt sind und die elektrische Kopplung während eines zweiten Zeitraums getrennt ist.

5. Phasensynchroner Mehrfach-LC-Tank-Oszillator nach Anspruch 1, wobei die Stufen (952, 954, 936, 938) des synchronen Oszillators während eines ersten Zeitraums elektrisch gekoppelt sind und die elektrische Kopplung während eines zweiten Zeitraums verringert ist.

6. Phasensynchroner Mehrfach-LC-Tank-Oszillator nach Anspruch 1, wobei die Vielzahl der Oszillatorstufen (952, 954, 936, 938) vier Oszillatorstufen umfasst.

7. Phasensynchroner Mehrfach-LC-Tank-Oszillator nach Anspruch 1, wobei die Vielzahl der Oszillatorstufen (952, 954, 936, 938) zwei Oszillatorstufen umfasst.

8. Phasensynchroner Mehrfach-LC-Tank-Oszillator nach Anspruch 1, wobei die induktive Kopplung unter Verwendung von zwei Mittelabgriffsinduktionsspulen erzielt wird.

9. Phasensynchroner Mehrfach-LC-Tank-Oszillator nach Anspruch 1, wobei die induktive Kopplung unter Verwendung von Induktionsspulen erzielt wird, die gegenseitig induktiv sind.

10. Phasensynchroner Mehrfach-LC-Tank-Oszillator nach Anspruch 1, wobei die induktive Kopplung unter Verwendung von Induktionsspulen erzielt wird, die Bereiche aufweisen, in denen Fluss enthalten ist und die im Wesentlichen nebeneinander bestehen.

11. Phasensynchroner Mehrfach-LC-Tank-Oszillator nach Anspruch 1, wobei mindestens eine der Oszillatorstufen (952, 954, 936, 938) einen Schalter (971, 972, 973, 975, 976, 977, 978) umfasst.

12. Phasensynchroner Mehrfach-LC-Tank-Oszillator nach Anspruch 1, wobei der phasensynchrone Mehrfach-LC-Tank-Oszillator in einem drahtlosen Sender-Empfänger verwendet wird.

13. Mehrfach-LC-Tank-Oszillator nach Anspruch 9, wobei die erste Induktionsspule und die zweite Induktionsspule so angeordnet sind, dass die Flussbereiche, die von den Induktionsspulen umgeben sind, überlappen.

14. Mehrfach-LC-Tank-Oszillator nach Anspruch 9, wobei die erste Induktionsspule und die zweite Induktionsspule auf drei Schichten eines integrierten Schaltkreises angeordnet sind.

15. Mehrfach-LC-Tank-Oszillator nach Anspruch 9, wobei der Abschnitt der ersten Induktionsspule auf mindestens zwei Schichten angeordnet ist, die sich unterhalb einer Schicht befinden, die die zweite Induktionsspule umfasst.

16. Mehrfach-LC-Tank-Oszillator nach Anspruch 9, wobei die erste Induktionsspule und die zweite Induktionsspule jeweils in einer hexagonalen Form angeordnet sind.

17. Mehrfach-LC-Tank-Oszillator nach Anspruch 9, wobei die erste Induktionsspule und die zweite Induktionsspule jeweils in einer Kreisform angeordnet sind.

18. Mehrfach-LC-Tank-Oszillator nach Anspruch 9, wobei die erste Induktionsspule auf eine zweite Schicht absinkt, wenn sich die erste Induktionsspule und die zweite Induktionsspule kreuzen.

19. Mehrfach-LC-Tank-Oszillator nach Anspruch 9, wobei die erste Induktionsspule und die zweite Induktionsspule auf höchstens zwei Schichten eines integrierten Schaltkreises angeordnet sind.

20. Mehrfach-LC-Tank-Oszillator nach Anspruch 9, der ferner Folgendes umfasst:
eine dritte Oszillatorstufe (956) mit einer dritten Induktionsspule (966) und eine vierte Oszillatorstufe (958) mit einer vierten Induktionsspule (968), wobei die erste Induktionsspule, die zweite Induktionsspule, die dritte Induktionsspule und die vierte Induktionsspule alle gegenseitig induktiv sind.

21. Mehrfach-LC-Tank-Oszillator nach Anspruch 9, der ferner Folgendes umfasst:
eine dritte Oszillatorstufe mit einer dritten Induktionsspule und eine vierte Oszillatorstufe mit einer vierten Induktionsspule, wobei die erste Induktionsspule, die zweite Induktionsspule, die dritte Induktionsspule und die vierte Induktionsspule alle gegenseitig induktiv sind und wobei die eine der Induktionsspulen auf eine zweite Schicht absinkt, wenn sich zwei der Induktionsspulen kreuzen.

22. Mehrfach-LC-Tank-Oszillator nach Anspruch 9, der ferner Folgendes umfasst:
eine dritte Oszillatorstufe mit einer dritten Induktionsspule und eine vierte Oszillatorstufe mit einer vierten Induktionsspule, wobei die erste Induktionsspule, die zweite Induktionsspule, die dritte Induktionsspule und die vierte Induktionsspule alle gegenseitig induktiv sind und wobei die erste Induktionsspule und die zweite Induktionsspule, die dritte Induktionsspule und die vierte Induktionsspule auf zwei Schichten eines integrierten Schaltkreises angeordnet sind und wobei die erste Induktionsspule und die zweite Induktionsspule auf einer oberen Schicht des integrierten Schaltkreises angeordnet sind.

## Revendications

1. Oscillateur à multiples circuits LC synchrones en phase comprenant :
une pluralité d'étages d'oscillateur (952, 954, 936, 938) configurés pour osciller de manière synchrone, la phase de chaque étage de la pluralité d'étages d'oscillateur étant sensiblement identique aux autres et
dans lequel la pluralité d'étages d'oscillateur (952, 954, 936, 938) est couplée inductivement, une première bobine d'induction (850, 962) et une deuxième bobine d'induction (860, 964) étant disposées sur une couche supérieure d'un circuit intégré,
**caractérisé en ce qu'**au niveau de point de croisement avec la deuxième bobine d'induction (860), une partie de la première bobine d'induction (850) est disposée sur au moins une couche (852) en dessous de la couche supérieure et la partie de la première bobine d'induction revient sur la couche supérieure après le point de croisement.

2. Oscillateur à multiples circuits LC synchrones en phase selon la revendication 1, dans lequel l'oscillation synchrone est sensiblement causée par couplage magnétique.

3. Oscillateur à multiples circuits LC synchrones en phase selon la revendication 1, dans lequel les étages d'oscillateur synchrones (952, 954, 936, 938) ne sont sensiblement pas couplés électriquement.

4. Oscillateur à multiples circuits LC synchrones en phase selon la revendication 1, dans lequel les étages d'oscillateur synchrones (952, 954, 936, 938) sont couplés électriquement durant une première période de temps et le couplage électrique est déconnecté durant une seconde période de temps.

5. Oscillateur à multiples circuits LC synchrones en phase selon la revendication 1, dans lequel les étages d'oscillateur synchrones (952, 954, 936, 938) sont couplés électriquement durant une première période de temps et le couplage électrique est réduit durant une seconde période de temps.

6. Oscillateur à multiples circuits LC synchrones en phase selon la revendication 1, dans lequel la pluralité d'étages d'oscillateur (952, 954, 936, 938) comporte quatre étages d'oscillateur.

7. Oscillateur à multiples circuits LC synchrones en phase selon la revendication 1, dans lequel la pluralité d'étages d'oscillateur (952, 954, 936, 938) comporte deux étages d'oscillateur.

8. Oscillateur à multiples circuits LC synchrones en phase selon la revendication 1, dans lequel le couplage inductif est réalisé en utilisant deux bobines d'induction à prise centrale.

9. Oscillateur à multiples circuits LC synchrones en phase selon la revendication 1, dans lequel le couplage inductif est réalisé en utilisant des bobines d'induction mutuellement inductives.

10. Oscillateur à multiples circuits LC synchrones en phase selon la revendication 1, dans lequel le couplage inductif est réalisé en utilisant des bobines d'induction dont les zones dans lesquelles le flux est confiné coexistent sensiblement.

11. Oscillateur à multiples circuits LC synchrones en phase selon la revendication 1, dans lequel au moins l'un des étages d'oscillateur (952, 954, 936, 938) comporte un commutateur (971, 972, 973, 975, 976, 977, 978).

12. Oscillateur à multiples circuits LC synchrones en phase selon la revendication 1, l'oscillateur à multiples circuits LC synchrones en phase étant utilisé dans un émetteur-récepteur sans fil.

13. Oscillateur à multiples circuits LC selon la revendication 9, dans lequel la première bobine d'induction et la deuxième bobine d'induction sont disposées de telle sorte que les zones de flux entourées par les bobines d'induction se chevauchent.

14. Oscillateur à multiples circuits LC selon la revendication 9, dans lequel la première bobine d'induction et la deuxième bobine d'induction sont disposées sur trois couches d'un circuit intégré.

15. Oscillateur à multiples circuits LC selon la revendication 9, dans lequel la partie de la première bobine d'induction est disposée sur au moins deux couches en dessous d'une couche qui comporte la deuxième bobine d'induction.

16. Oscillateur à multiples circuits LC selon la revendication 9, dans lequel la première bobine d'induction et la deuxième bobine d'induction sont agencées selon une forme hexagonale.

17. Oscillateur à multiples circuits LC selon la revendication 9, dans lequel la première bobine d'induction et la deuxième bobine d'induction sont agencées selon une forme circulaire.

18. Oscillateur à multiples circuits LC selon la revendication 9, dans lequel la première bobine d'induction descend jusqu'à une seconde couche quand la première bobine d'induction et la deuxième bobine d'induction se croisent.

19. Oscillateur à multiples circuits LC selon la revendication 9, dans lequel la première bobine d'induction et la deuxième bobine d'induction sont disposées dans au plus deux couches d'un circuit intégré.

20. Oscillateur à multiples circuits LC selon la revendication 9, comportant en outre : un troisième étage d'oscillateur (956) ayant une troisième bobine d'induction (966) ; et un quatrième étage d'oscillateur (958) ayant une quatrième bobine d'induction (968) ; dans lequel la première bobine d'induction, la deuxième bobine d'induction, la troisième bobine d'induction et la quatrième bobine d'induction sont toutes mutuellement inductives.

21. Oscillateur à multiples circuits LC selon la revendication 9, comportant en outre : un troisième étage d'oscillateur ayant une troisième bobine d'induction ; et un quatrième étage d'oscillateur ayant une quatrième bobine d'induction ; dans lequel la première bobine d'induction, la deuxième bobine d'induction, la troisième bobine d'induction et la quatrième bobine d'induction sont toutes mutuellement inductives et dans lequel l'une des bobines d'induction descend jusqu'à une seconde couche quand deux des bobines d'induction se croisent.

22. Oscillateur à multiples circuits LC selon la revendication 9, comportant en outre : un troisième étage d'oscillateur ayant une troisième bobine d'induction ; et un quatrième étage d'oscillateur ayant une quatrième bobine d'induction ; dans lequel la première bobine d'induction, la deuxième bobine d'induction, la troisième bobine d'induction et la quatrième bobine d'induction sont toutes mutuellement inductives et dans lequel la première bobine d'induction et la deuxième bobine d'induction, la troisième bobine d'induction et la quatrième bobine d'induction sont disposées sur deux couches d'un circuit intégré et dans lequel la première bobine d'induction et la deuxième bobine d'induction sont disposées sur une couche supérieure du circuit intégré.
